(19) Europäisches Patentamt
European Patent Office
Office européen des brevets

(11) **EP 1 936 680 B1**

(12) **FASCICULE DE BREVET EUROPEEN**

(45) Date de publication et mention
de la délivrance du brevet:
**15.08.2012  Bulletin 2012/33**

(51) Int Cl.:
***H01L 23/532*** *(2006.01)*          *H01L 21/768* *(2006.01)*
*H01L 23/522* *(2006.01)*

(21) Numéro de dépôt: **07123467.8**

(22) Date de dépôt: **18.12.2007**

(54) **Elément d'interconnexion à base de nanotubes de carbone**

Interconnect-Element auf der Basis von Kohlenstoff-Nanokanälen

Interconnection element based on carbon nanotubes

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité:  **21.12.2006  FR 0655839**

(43) Date de publication de la demande:
**25.06.2008  Bulletin 2008/26**

(73) Titulaire: **Commissariat à l'Énergie Atomique et aux Énergies Alternatives**
**75015 Paris (FR)**

(72) Inventeurs:
• **Dijon, Jean**
**38800, CHAMPAGNIER (FR)**
• **Pantigny, Philippe**
**38640, CLAIX (FR)**

(74) Mandataire: **Ilgart, Jean-Christophe**
**BREVALEX**
**95 rue d'Amsterdam**
**75378 Paris Cedex 8 (FR)**

(56) Documents cités:
**EP-A- 0 259 614          EP-A- 1 361 608**
**US-A1- 2003 021 966      US-A1- 2005 104 056**
**US-A1- 2005 142 933      US-A1- 2006 220 067**
**US-A1- 2006 278 901**

## Description

### DOMAINE TECHNIQUE

La présente invention concerne le domaine de la microélectronique et plus particulièrement celui des éléments d'interconnexion dans un circuit intégré.

### ÉTAT DE LA TECHNIQUE ANTÉRIEURE

Les connexions électriques entre deux plans différents d'un circuit intégré sont classiquement réalisées au moyen de vias. Un via peut être considéré comme un trou traversant une couche d'isolant séparant une couche conductrice inférieure et une couche conductrice supérieure, ce trou étant rempli d'un métal, typiquement du cuivre, pour assurer la connexion électrique entre les deux couches conductrices.

Ce type de connexion est satisfaisant pour des motifs d'interconnexion micrométriques. Toutefois, pour des motifs de plus faibles dimensions latérales, on est contraint d'utiliser des vias de diamètre inférieur à 100 nm voire à 50 nm. Le rapport hauteur/diamètre du trou devient alors élevé, ce qui rend le dépôt métallique particulièrement délicat du fait que le trou en question a tendance à s'obturer en sa partie supérieure avant d'être comblé. De surcroît, plus le diamètre du via est faible et plus les phénomènes d'électromigration sont sensibles, ce qui limite tant le courant maximum que l'on peut y faire passer que sa durée de vie. Enfin, la réduction du diamètre des vias se traduit par une résistance d'interconnexion plus élevée, ce qui réduit d'autant la vitesse maximale de fonctionnement du circuit intégré.

Pour pallier les inconvénients précités, il a été proposé de remplacer le métal du via par des faisceaux de nanotubes de carbone. Du fait de leurs excellentes propriétés conductrices, de leur stabilité mécanique et thermique, les nanotubes de carbone se prêtent en effet bien à la réalisation de vias de très faible diamètre. Un tel via est décrit par exemple dans la demande WO 01/61753.

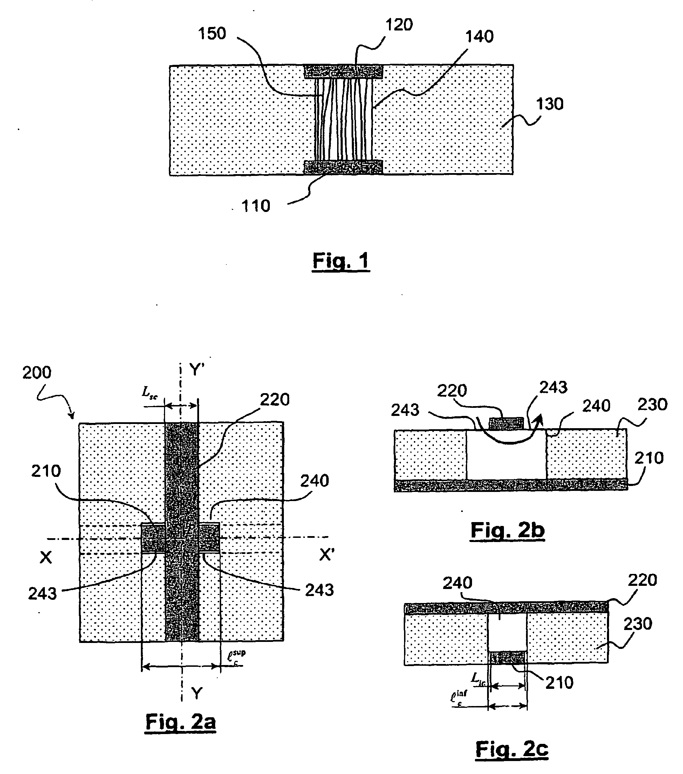

La Fig. 1 illustre un via à base de nanotubes connu de l'état de la technique. Pour des raisons de simplification le substrat n'a pas été représenté.

Le via réalise la connexion entre un conducteur inférieur 110 et un conducteur supérieur 120, séparés par une couche de diélectrique 130. Le trou 140 contient des nanotubes de carbone (NTC) 150 s'étendant du conducteur inférieur au conducteur supérieur.

Les NTC sont réalisés par synthèse catalytique. Plus précisément, un catalyseur (typiquement des nanoparticules de nickel) est déposé sur le conducteur inférieur pour initier la formation de NTC lors d'une phase de dépôt chimique en phase vapeur (CVD). Les NTC croissent alors du conducteur inférieur vers le conducteur supérieur. Le dépôt du catalyseur doit être localisé dans le fond du via. A défaut, si un dépôt de catalyseur intervient sur les parois du trou, on assiste à une croissance latérale de NTC qui perturbe voire stoppe la croissance du faisceau vertical, seul participant à la connexion électrique entre les conducteurs inférieur et supérieur. La prévention du dépôt sur les parois du trou est d'autant plus critique que son diamètre est faible.

Afin d'éviter la croissance latérale parasite de NTC, il a été proposé dans l'article de F. Kreupl intitulé « Carbon Nanotubes for Interconnect Applications » publié dans Microelectron. Eng. 64, pages 399-408, 2002, de procéder d'abord au dépôt d'un plot de catalyseur sur le conducteur inférieur avant de procéder au dépôt de la couche diélectrique. Le trou est ensuite gravé jusqu'à la couche de catalyseur avant de faire croître les NTC. Cette technique est très délicate à mettre en oeuvre car elle requiert l'arrêt de la gravure sur une couche de catalyseur d'une épaisseur de quelques nanomètres. En outre, les propriétés physico-chimiques de la couche de catalyseur peuvent être impactées par les phases de dépôt et de gravure de la couche diélectrique, et son activité catalytique peut s'en trouver par conséquent sérieusement affectée.

Quel que soit le mode de dépôt du catalyseur retenu, on fait croître les NTC à partir du conducteur inférieur puis l'on procède généralement à une planarisation par polissage mécanochimique (*chemical mechanical planarization* ou CMP). Le conducteur supérieur est ensuite déposé sur la surface planarisée.

La principale difficulté qui se présente dans cette technique est d'obtenir d'un contact ohmique entre les NTC et les conducteurs inférieur et supérieur. Le dépôt du conducteur supérieur se fait à une température relativement basse et un recuit grèverait le budget thermique du circuit intégré.

Le document EP-A-1361608 décrit un élément d'interconnexion à base de nanotubes de carbone permettant de connecter une région active à une couche conductrice d'un circuit intégré.

Un premier but de la présente invention est de réaliser un élément d'interconnexion à base de nanotubes de carbone présentant un bon contact électrique entre les nanotubes et les conducteurs à interconnecter.

Un second but de la présente invention est de supprimer ou de réduire sensiblement la croissance latérale des NTC sans risquer d'endommager la couche de catalyseur.

Un troisième but de la présente invention est de se passer de l'étape de polissage après la croissance des nanotubes de carbone.

### EXPOSÉ DE L'INVENTION

La présente invention est définie par un élément d'interconnexion selon la revendication 1 et par un procédé de fabrication d'un tel élément selon les revendications 18 et 21. Des modes avantageux de réalisation sont précisés dans les revendications dépendantes.

## BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles :

La Fig. 1 montre un élément d'interconnexion connu de l'état de la technique ;

Les Figs. 2a à 2c montrent la structure générale d'un élément d'interconnexion selon l'invention, avant la phase de croissance des nanotubes de carbone ;

Les Figs. 3a et 3b illustrent schématiquement un élément d'interconnexion selon un premier mode de réalisation de l'invention ;

Les Figs. 4a et 4b illustrent schématiquement un élément d'interconnexion selon un second mode de réalisation de l'invention ;

Les Figs. 5a et 5b illustrent schématiquement un élément d'interconnexion selon un troisième mode de réalisation de l'invention ;

Les Figs 6a à 6j illustrent un procédé de fabrication de l'élément d'interconnexion selon le second mode de réalisation de l'invention ;

Les Figs. 7a à 7i illustrent un procédé de fabrication de l'élément d'interconnexion selon le troisième mode de réalisation de l'invention ;

Les Figs. 8a et 8b illustrent l'application de l'élément d'interconnexion selon l'invention pour la réalisation de plusieurs niveaux d'interconnexion.

## EXPOSÉ DÉTAILLÉ DE MODES DE RÉALISATION PARTICULIERS

L'idée de base de l'invention est de réaliser un élément d'interconnexion ayant une structure en pont au dessus d'une cavité réalisée dans la couche diélectrique, ladite cavité débouchant d'une part sur le conducteur inférieur et formant, d'autre part, des évents de part et d'autre du conducteur supérieur.

De manière générale, l'invention permet de réaliser un élément destiné à interconnecter au moins deux connecteurs d'un circuit microélectronique. Cet élément est ensuite placé dans un réacteur dans lequel on procède à la croissance des nanotubes de carbone.

Il est important de comprendre que la structure de l'élément avant et après la phase de croissance des NTC fait partie de la présente invention.

La Fig. 2a montre une vue de dessus de l'élément d'interconnexion, avant la phase de croissance des NTC. Les Figs. 2b et 2c montrent respectivement une coupe du même élément selon l'axe XX' du conducteur inférieur et selon l'axe YY' du conducteur supérieur.

Pour des raisons de simplification, le substrat n'a pas été représenté sur les Figs. 2a à 2c. Il ne le sera pas non plus pour les figures suivantes.

L'élément d'interconnexion 200 comprend un conducteur inférieur 210 ayant ici la forme d'une ligne conductrice. Le conducteur inférieur est recouvert d'une couche diélectrique 230 sur laquelle se trouve le conducteur supérieur 220, représenté ici également sous la forme d'une ligne conductrice orthogonale à la première. Il est clair que l'invention ne se limite pas à des lignes conductrices orthogonales. Les conducteurs pourront notamment présenter des motifs plus complexes, connexes ou non, ainsi que des intersections non orthogonales sans sortir pour autant du cadre de la présente invention. Les conducteurs inférieurs sont par exemple des couches métalliques de Cu ou Al. La couche diélectrique 230 est par exemple du $SiO_2$ ou du $Si_3N_4$ ou encore du SiOC.

Une cavité 240 est aménagée dans la couche diélectrique 230 de sorte qu'elle débouche d'une part sur le conducteur inférieur 210 et d'autre part sur le conducteur supérieur. Le conducteur supérieur 220 forme un pont au dessus de la cavité et du conducteur inférieur. Cette cavité forme au niveau où elle débouche sur la face supérieure de l'oxyde, deux évents 243 de part et d'autre du conducteur supérieur 220. Pour ce faire, la dimension $\ell_c^{sup}$ de la cavité, prise selon un axe orthogonal au conducteur supérieur, au point d'interconnexion $P$ et dans le plan de la face supérieure de l'oxyde, est choisie sensiblement supérieure à la largeur $L_{sc}$ de ce conducteur.

La taille des évents 243 est choisie suffisamment grande pour permettre la libre circulation d'un flux de gaz dans la cavité, sous le conducteur supérieur, comme indiqué par la flèche en Fig. 2b.

Avantageusement, au point d'interconnexion $P$, la dimension $\ell_c^{inf}$ de la cavité, prise selon un axe orthogonal au conducteur inférieur, au niveau où elle débouche sur ce dernier, est choisie légèrement supérieure à la largeur $L_{ic}$ du conducteur, de sorte que sa face supérieure de celui-ci est dégagée sur toute sa largeur au fond de la cavité.

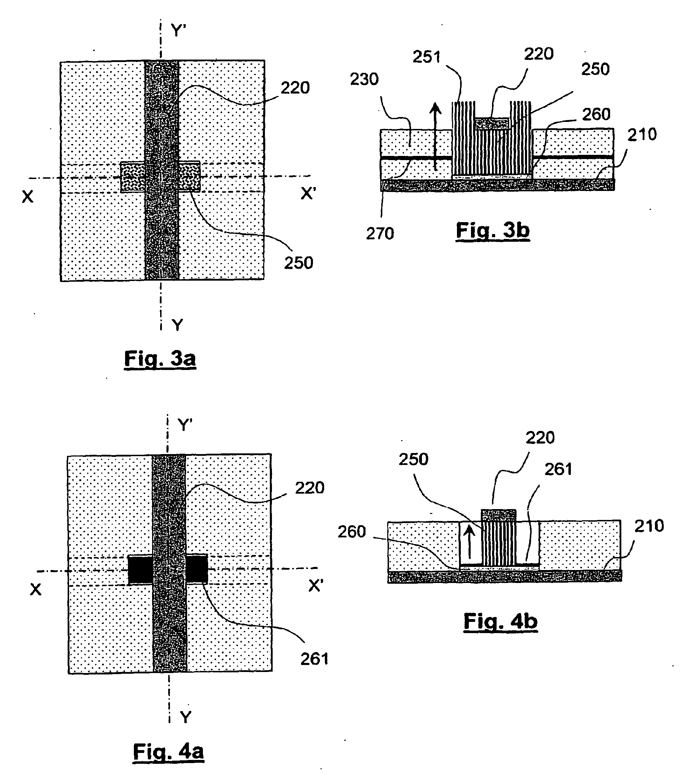

Les Figs. 3a et 3b illustrent un élément d'interconnexion selon un premier mode de réalisation de l'invention. La Fig. 3a, montre la vue supérieure dudit élément, après la phase de croissance des NTC. La Fig. 3b montre la coupe de cet élément le long de l'axe XX' .

Dans ce mode de réalisation, une couche de catalyseur 260 a été déposée sur la face supérieure du conducteur inférieur 210 au fond de la cavité 240. Avantageusement, on déposera préalablement à la couche de catalyseur, une couche dite barrière, prévenant la diffusion du catalyseur dans le conducteur inférieur. Les évents 243 situés de part et d'autre du conducteur supérieur permettent la circulation des gaz pendant la phase de synthèse catalytique des NTC. Les nanotubes 250 se forment à partir de la face supérieure du conducteur inférieur et croissent librement jusqu'à rencontrer la face inférieure du conducteur supérieur. Au niveau des évents 243, la croissance des nanotubes se poursuit au delà de la couche de diélectrique 230, de chaque côté du conducteur supérieur 220, comme indiqué en 251. Le surplomb des NTC en 251 peut être éliminé par une étape supplémentaire facultative de planarisation. Cette étape sera nécessaire si l'on souhaite réaliser plusieurs niveaux d'interconnexion, comme on le verra plus loin.

Les Figs. 4a et 4b illustrent un élément d'interconnexion, selon un second mode de réalisation de l'invention. Comme précédemment, la Fig. 4a montre la vue supérieure dudit élément, après la phase de croissance des NTC et la Fig. 4b montre la coupe de cet élément le long de l'axe XX'.

Ce second mode de réalisation diffère du premier en ce que la couche de catalyseur 260 est partiellement recouverte par une couche protectrice ou inhibitrice 261. Plus précisément cette couche inhibitrice recouvre une zone de la couche de catalyseur 260 correspondant sensiblement à la projection orthogonale des évents au fond de la cavité. Ainsi la croissance des NTC est inhibée au regard des évents, ce qui limite la croissance des NTC aux zones en regard du conducteur supérieur et du conducteur inférieur. La circulation des gaz s'en trouve également facilitée, ce qui favorise d'autant la croissance des NTC dans la cavité.

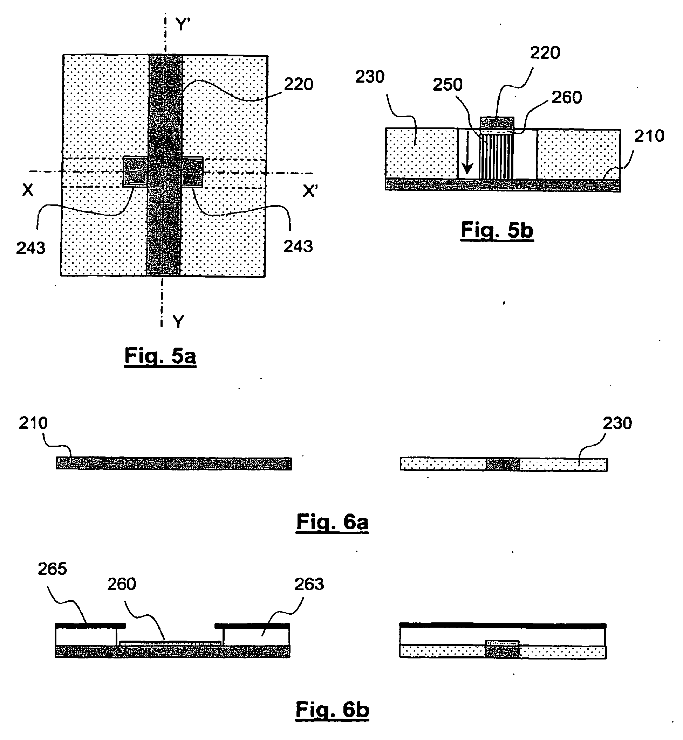

Les Figs. 5a et 5b illustrent un élément d'interconnexion selon un troisième mode de réalisation de l'invention. Comme précédemment, la Fig. 5a montre la vue supérieure dudit élément, après la phase de croissance des NTC et la Fig. 5b montre la coupe de cet élément le long de l'axe XX'.

Ce mode préféré de réalisation se distingue des précédents en ce que la couche de catalyseur 260 est située sur la face inférieure du conducteur supérieur 220. La croissance des NTC se fait par conséquent à partir de cette surface, jusqu'à ce ces derniers rencontrent la face supérieure du conducteur inférieur 210. On remarquera que ce mode de réalisation n'engendre pas de croissance parasite sans nécessiter pour autant le dépôt d'une couche inhibitrice. En outre, les évents 243 permettent une circulation des gaz pendant toute la phase de croissance. De préférence, une couche permettant l'amélioration du contact électrique entre les nanotubes et le conducteur inférieur pourra être déposée directement à la surface de ce dernier.

Selon un quatrième mode de réalisation non représenté, la couche de catalyseur 260 est déposée à la fois sur la face supérieure du conducteur inférieur 210 comme dans le premier ou le second mode de réalisation et sur la face inférieure du conducteur supérieur 220, comme dans le troisième mode de réalisation. Ainsi la croissance des nanotubes se fait simultanément à partir de ces deux faces selon deux sens opposés. Plus précisément un premier faisceau de nanotubes croîtra de la face supérieure du conducteur inférieur vers la face inférieure du conducteur supérieur et un second faisceau de nanotubes croîtra de la face inférieure du conducteur supérieur vers face supérieure du conducteur inférieur. Ce mode de réalisation permet d'accroître la densité de NTC dans la cavité et par conséquent la qualité de la connexion électrique.

Selon une variante des premier à quatrième modes de réalisation, la couche de diélectrique 230 intègre dans son épaisseur une couche conductrice 270, par exemple une couche métallique. Cette couche conductrice a été représentée à titre d'illustration en Fig. 3b pour le premier mode de réalisation. En polarisant convenablement la couche conductrice 270, on peut accroître la conductivité des NTC 250.

Les Figs. 6a à 6j montrent les étapes du procédé de fabrication de l'élément d'interconnexion selon le second mode de réalisation de l'invention. Le procédé de fabrication d'un élément d'interconnexion selon le premier mode de réalisation ne sera pas décrit explicitement pour éviter les redondances. On précisera simplement plus loin en quoi il diffère du second mode de réalisation.

Sur chacune des Figs. 6a à 6j on a représenté à gauche une coupe de l'élément d'interconnexion selon l'axe XX' du conducteur inférieur et à droite une coupe selon l'axe YY' du conducteur supérieur.

La première étape du procédé consiste à déposer une couche d'isolant A, référencé en 230, sur le substrat (non représenté) et de réaliser le conducteur inférieur 210 dans l'épaisseur de la couche d'isolant. On utilise pour ce faire une technique de type Damascène, bien connue de l'état de la technique : les motifs conducteurs sont gravés dans la couche d'isolant puis remplis de métal, par exemple du cuivre. La surface supérieure de l'isolant est ensuite polie pour obtenir la structure représentée en Fig. 6a. Elle est constituée ici d'une ligne conductrice 210 formée dans la couche d'isolant 230.

On procède ensuite au dépôt de la couche de catalyseur 260 sur le conducteur inférieur 210. Pour ce faire, on dépose préalablement sur le conducteur inférieur une couche sacrificielle 263 et un masque dur 265 définissant le motif du catalyseur. La gravure est effectuée par lithographie (par exemple par faisceau d'électrons). Le résultat après dépôt du catalyseur est représenté en Fig. 6b.

Avantageusement, une couche barrière de 10 à 50 nm (non représentée) est déposée préalablement à la couche de catalyseur sur le conducteur inférieur. La couche barrière peut être réalisée par exemple avec du titane (Ti), du nitrure de titane (TiN), du tantale (Ta), du nitrure de tantale (TaN) ou de l'aluminium (Al).

Le catalyseur dépend du type de NTC que l'on souhaite faire croître. De manière générale, on utilisera des particules métalliques (nickel, cobalt, fer, yttrium, platine, etc. ou un alliage des matériaux cités précédemment) Dans certains cas, la couche barrière n'est pas nécessaire.

A titre d'exemple, pour réaliser des nanotubes préférentiellement de type multifeuillet (MWNTC), on choisira :

- une couche de nickel de 3 nm d'épaisseur déposée sur une couche barrière en TiN ou TaN (par exemple de 10 nm) ;

- un alliage nickel-palladium $Pd_{0,25} Ni_{0,75}$ de 3 nm d'épaisseur ;
- une bicouche dont chaque couche est définie par (10 nm d'Al, 3 nm de Ni), déposée directement sur le cuivre (premier ou second conducteur) ;
- une bicouche dont chaque couche est définie par (5 nm de Si, 3 nm de Fe).

En revanche, si l'on souhaite réaliser des nanotubes préférentiellement de type monofeuillet (SWNTC), on choisira préférentiellement :

- une bicouche dont chaque couche est définie par (20 nm d'Al, 0.5 nm de Fe, 0.2 nm d'Al) ;
- une bicouche dont chaque couche est définie par (5 nm de Si, 0.5 nm de Fe),
- une bicouche dont chaque couche est définie par (3 nm de Si, 1 nm de Co). L'homme du métier saura adapter les épaisseurs de catalyseur pour obtenir un mélange donné de nanotubes de type multifeuillet et de type monofeuillet.

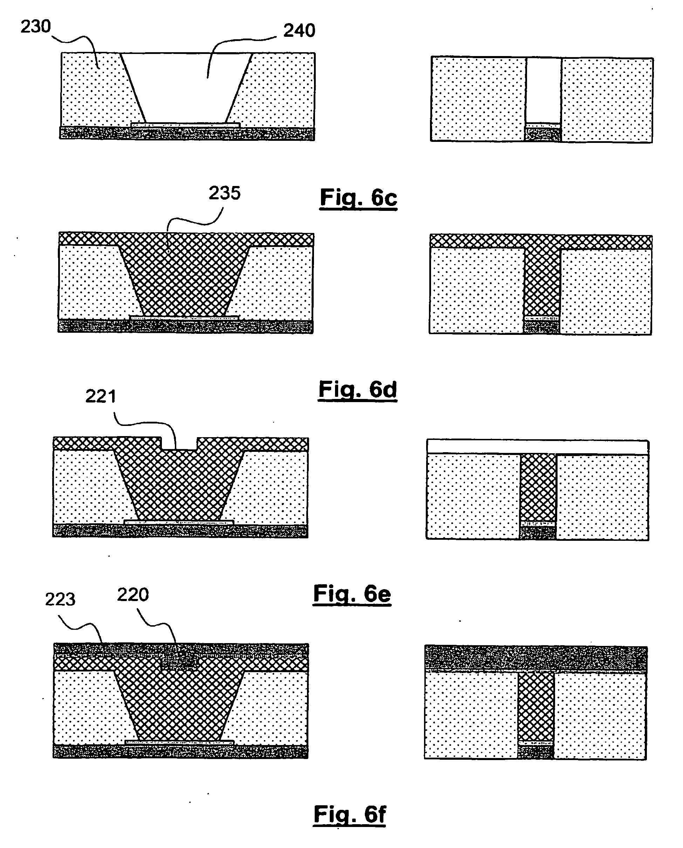

Après dépôt du catalyseur, on élimine ensuite la couche sacrificielle 263 et l'on dépose une nouvelle couche d'isolant A, puis on ouvre une cavité 240 dans cette couche d'isolant au moyen d'une gravure chimique ou réactive (RIE). Le profil de la gravure peut être avantageusement choisi en pente comme représenté en Fig. 6c. La gravure s'arrête sur la couche de catalyseur.

On remplit ensuite la cavité avec un second isolant B, indiqué en 235, puis on procède à la planarisation, de la surface supérieure pour obtenir la structure représentée en Fig. 6d.

On réalise ensuite le conducteur supérieur dans l'isolant B par un procédé de type Damascène, représenté en Figs. 6e à 6g.

Plus précisément, on grave dans l'isolant B les motifs 221 du conducteur supérieur (ici une simple ligne conductrice selon l'axe YY'). La gravure est arrêtée à l'interface avec l'isolant A. Le résultat de la gravure est représenté en Fig. 6e.

On dépose ensuite une couche de contact 223, par exemple du palladium ou du Titane, puis le conducteur supérieur 220, en cuivre par exemple. Le résultat de l'opération est représenté en Fig. 6f.

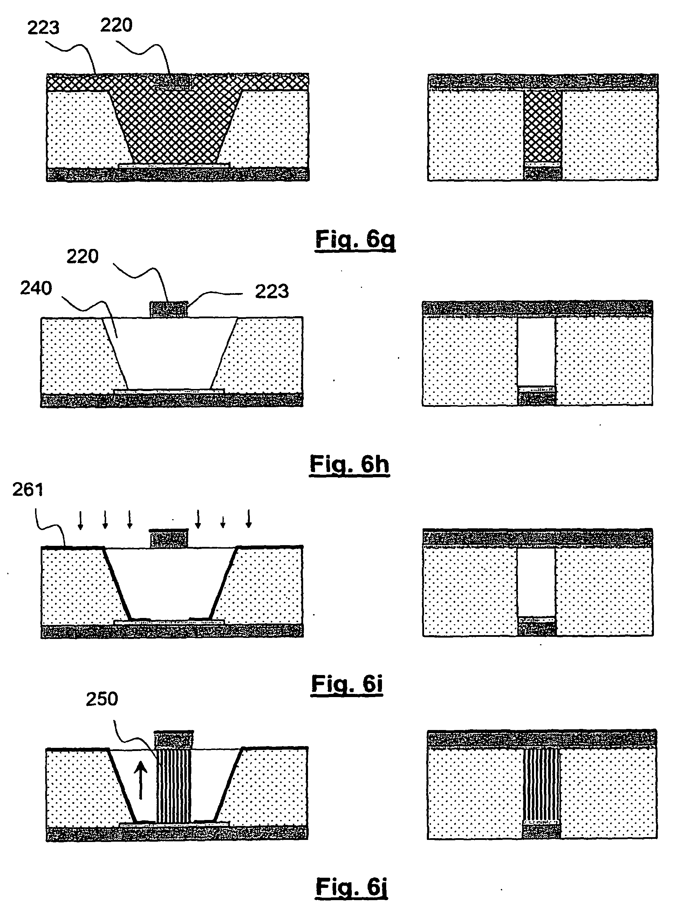

On planarise la surface supérieure par une planarisation CMP jusqu'à faire apparaître les motifs de conducteur supérieur, ici une simple ligne conductrice, comme représenté en Fig. 6g.

On effectue alors la gravure complète de l'isolant B, ce qui dégage la cavité 240 comme indiqué en Fig. 6h. On dépose ensuite une couche protectrice 261 au moyen d'une technique de dépôt directif. La couche protectrice est avantageusement mais non nécessairement réalisée en matériau isolant A. Le résultat de l'opération est indiqué en Fig. 6i.

Enfin, on fait croître les nanotubes de carbone. Le catalyseur étant situé sur le conducteur inférieur, la croissance s'effectue de bas en haut. Le résultat final est indiqué en Fig. 6j.

Le procédé de croissance dépend du type de NTC que l'on souhaite faire croître, à savoir, pour des nanotubes préférentiellement de type multifeuillet :

- on effectue une montée en température jusqu'à 540°C en 10 mn dans un réacteur sous 0.4 mBar de $H_2$ ;
- on vide l'enceinte du réacteur;
- on procède à la croissance des NTC à 540°C sous 0.4 mBar de $C_2H_2$ ;
- on descend en température sous flux de $H_2$ ou He, de manière à refroidir rapidement le dispositif.

pour des nanotubes préférentiellement de type monofeuillet :

- on effectue une montée en température jusqu'à 700 °C dans un réacteur sous 0.4 mBar de $H_2$ ;
- on vide l'enceinte du réacteur;
- on procède à la croissance des NTC à 700°C sous atmosphère d'un mélange $C_2H_2$, $H_2$, He à 0.4 mBar avec un débit de $C_2H_2$ de 5 sccm, $H_2$ 50 sccm et He 50 sccm.

L'homme du métier saura adapter les épaisseurs de catalyseur et les conditions de croissance pour obtenir un mélange donné de NWNTC et de SWNTC.

Il convient de noter que le procédé de fabrication de l'élément d'interconnexion selon le premier mode de réalisation ne diffère de celui exposé ci-dessus que par l'omission du dépôt de la couche protectrice (cf. Fig. 6i).

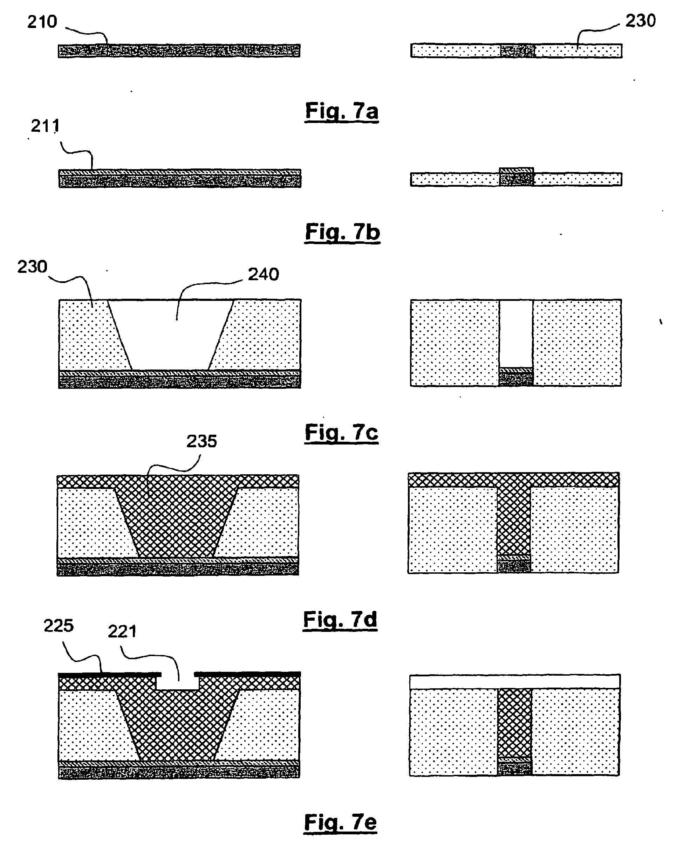

Les Figs. 7a à 7i illustrent les étapes du procédé de fabrication de l'élément d'interconnexion selon le troisième mode de réalisation de l'invention.

La première étape, voir Fig. 7a, est identique à celle décrite en relation avec la Fig. 6a à savoir la formation du premier conducteur 210 dans la couche de diélectrique A , indiquée en 230, par un procédé de type Damascène.

On dépose ensuite, optionnellement mais préférentiellement, une couche de contact 211, par exemple du palladium ou du titane par voie électrochimique sur le conducteur inférieur, par exemple du cuivre. Le résultat du dépôt apparaît en Fig. 7b.

On procède ensuite au dépôt d'une couche d'isolant A comme montré en Fig. 7c, puis à l'ouverture d'une cavité 240 au dessus du conducteur inférieur. La gravure de la cavité est avantageusement en pente et s'arrête au niveau de la couche de contact, cf. Fig. 7c.

On remplit alors la cavité par un second isolant B, référencé en 235. La face supérieure est planarisée par CMP pour obtenir le profil de la Fig. 7d.

On dépose ensuite un masque dur 225 sur l'isolant B et l'on grave les motifs 221 du conducteur supérieur (ici une simple ligne conductrice dans l'axe YY') dans cet isolant, comme montré en Fig. 7e. La gravure est arrêtée au niveau de l'isolant A. Le masque dur permet de réaliser une casquette surplombant les flancs de gravure.

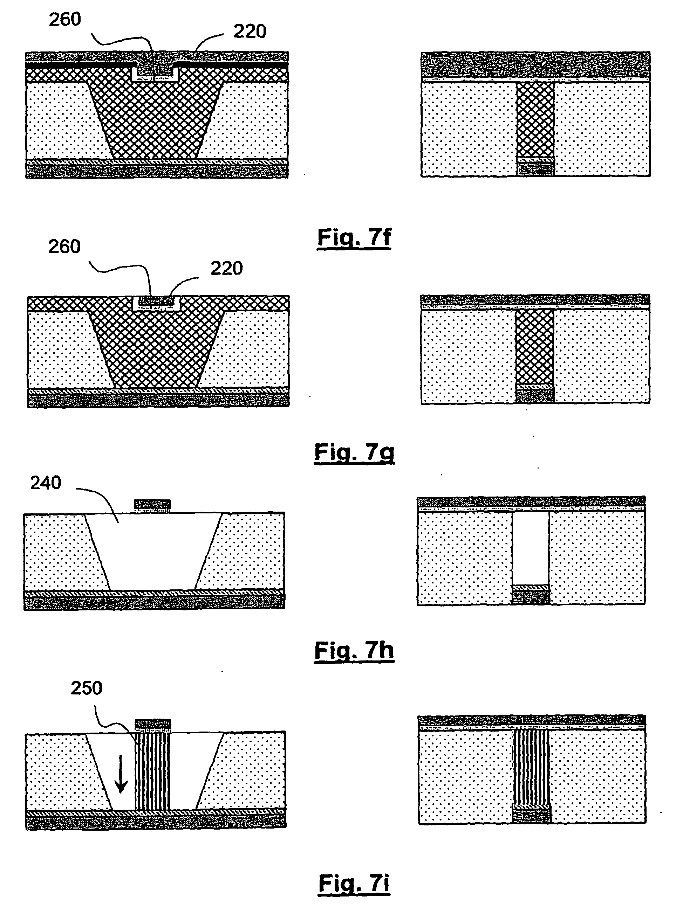

A l'étape suivante, on procède au dépôt de la couche de catalyseur 260, suivi, le cas échéant, par celui d'une couche barrière (non représentée). Les matériaux utilisés pour le catalyseur et la couche barrière sont les mêmes que ceux cités pour le second mode de réalisation. La forme en casquette du masque dur permet d'éviter le dépôt de catalyseur sur les flancs de gravure. On dépose ensuite le conducteur supérieur, de préférence du cuivre. Le résultat de cette étape est montré en Fig. 7f.

On planarise ensuite par CMP la face supérieure de manière à faire apparaître à la surface de l'isolant B les motifs du conducteur supérieur. Le résultat de la planarisation est montré en Fig. 7g.

On procède ensuite à la gravure complète de l'isolant B, ce qui dégage la cavité 240. On obtient alors la structure en pont représentée à la Fig. 7h.

Enfin, on fait croître les NTC 250 dans les mêmes conditions que celles décrites précédemment pour le second mode de réalisation. Bien entendu, la croissance se fait ici à partir de la face inférieure du conducteur supérieur jusqu'à ce que les nanotubes rejoignent la couche de contact 211 (ou en l'absence de la couche de contact, le conducteur inférieur 210). On aboutit ainsi à la structure représentée en Fig. 7i.

Dans les modes de réalisation envisagés ci-dessus, l'isolant ou diélectrique A peut être de la silice ou un matériau à faible coefficient diélectrique *(low k dielectric)* utilisé couramment en microélectronique. L'isolant B peut être avantageusement du silsesquioxane hydrogéné (HSQ) ou un nitrure de silicium. Les isolants A et B sont choisis pour permettre une gravure de B de très bonne sélectivité par rapport à A.

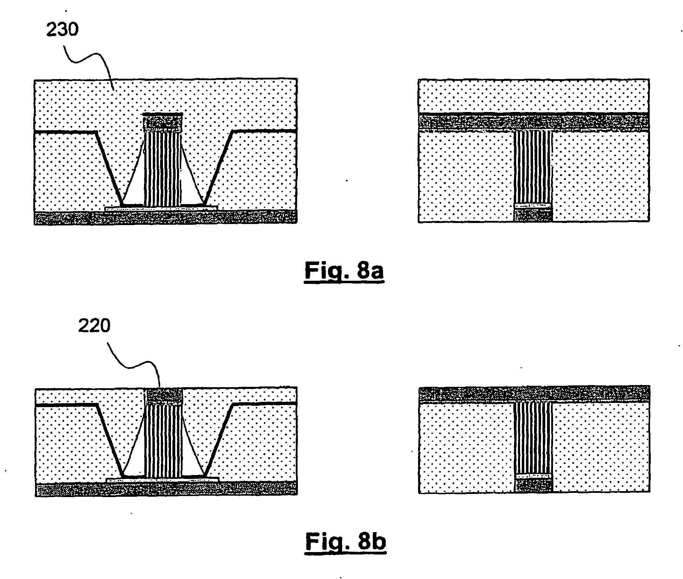

L'élément d'interconnexion selon l'invention peut être utilisé pour réaliser plusieurs niveaux d'interconnexion. Pour ce faire, partant de la structure représentée en Fig. 6i ou 7h, on dépose une couche d'isolant A, référencé en 230, pour recouvrir le conducteur supérieur comme indiqué en Fig. 8a. On planarise ensuite la surface supérieure par polissage CMP, jusqu'à ce qu'à ce que l'on atteigne le conducteur supérieur, c'est-à-dire que l'on obtienne le profil indiqué en Fig. 8b. Le conducteur supérieur 220 peut alors jouer le rôle que jouait précédemment le conducteur inférieur 210 au début du processus. Autrement dit, la séquence constituée par les étapes des Figs 6a-6j ou Figs. 7a-7i, suivies de celles des Figs. 8a et 8b peut être itérée de manière à connecter plusieurs niveaux dans un circuit microélectronique.

L'élément de connexion selon l'invention trouve notamment application dans la réalisation de vias de très faibles diamètres pour des circuits intégrés VLSI. Il permet également avantageusement de réaliser le premier niveau d'interconnexion sur des transistors. Dans ce cas le conducteur inférieur est une électrode de source, une électrode de drain ou une électrode de grille, réalisée par exemple en siliciure de nickel ou de cobalt.

## Revendications

1. Elément destiné à interconnecter au moins un premier conducteur (210) et un second conducteur (230) d'un circuit microélectronique, comprenant :

   - le premier conducteur (210), dit conducteur inférieur ;
   - une couche de diélectrique (230) sur ledit premier conducteur ;
   - le second conducteur (220), dit conducteur supérieur, sur ladite couche de diélectrique ;
   - une cavité (240) dans la couche de diélectrique débouchant d'une part sur le conducteur inférieur et d'autre part sur le conducteur supérieur,

   **caractérisé en ce que** :

   le conducteur supérieur (220) forme un pont au dessus du conducteur inférieur (210) et que la cavité (240) forme au niveau où elle débouche sur le conducteur supérieur deux évents (243) de part et d'autre de ce dernier ;
   une couche de catalyseur, favorisant la croissance de nanotubes de carbone, est prévue sur la face supérieure dudit conducteur inférieur ou sur la face inférieure dudit conducteur supérieur ;
   et que ledit élément comprend en outre des nanotubes de carbone formés à partir de ladite couche de catalyseur.

2. Elément selon la revendication 1, **caractérisé en ce que** la couche de catalyseur (260), est située sur la face supérieure dudit conducteur inférieur.

3. Elément selon la revendication 2, **caractérisé en ce qu'**il comprend une couche de barrière de diffusion entre la face supérieure du conducteur inférieur (210) et la couche de catalyseur (260).

4. Elément selon la revendication 2 ou 3, **caractérisé en ce qu'**il comprend une couche inhibitrice (261) de la croissance de nanotubes de carbone, ladite couche inhibitrice étant déposée sur la couche de catalyseur (260), le dépôt couvrant une zone correspondant à la projection orthogonale des évents sur cette dernière.

5. Elément selon l'une des revendications 2 à 4, caractérisé en qu'il comprend un faisceau de nanotubes électriquement conducteurs (250) situé dans la cavité, ledit faisceau s'étendant de la couche de catalyseur (260) à la face inférieure du conducteur supérieur.

6. Elément selon l'une des revendications 2 à 4, **caractérisé en ce qu'**il comprend une couche de contact électrique (223) située directement sous le conducteur supérieur.

7. Elément selon la revendication 1, **caractérisé en ce que** la couche de catalyseur (260) est située sur la face inférieure dudit conducteur supérieur (220).

8. Elément selon la revendication 7, **caractérisé en ce qu'**il comprend une couche de barrière de diffusion entre la face inférieure du conducteur supérieur (220) et la couche de catalyseur (260).

9. Elément selon la revendication 7 ou 8, **caractérisé en ce qu'**il comprend un faisceau de nanotubes de carbone (250) situé dans la cavité, ledit faisceau s'étendant de la couche de catalyseur (260) à la face supérieure du conducteur inférieur (210).

10. Elément selon la revendication 7 ou 8, **caractérisé en ce qu'** il comprend une couche de contact électrique (211) située directement sur le conducteur inférieur.

11. Elément selon la revendication 6 ou 10, **caractérisé en ce qu'**il comprend un faisceau de nanotubes de carbone (250) situé dans la cavité, ledit faisceau s'étendant de la couche de catalyseur à la couche de contact électrique (211, 223).

12. Elément selon l'une des revendications 6, 10, 11, **caractérisé en ce que** le matériau constitutif de la couche de contact électrique est du palladium ou du nickel.

13. Elément selon la revendication 3 ou 8, **caractérisé en ce que** le matériau constitutif de la couche de barrière de diffusion est du titane, du nitrure de titane, du tantale ou du nitrure de tantale.

14. Elément selon l'une des revendications 2 à 13, **caractérisé en ce que** la couche de catalyseur comprend des nanoparticules métalliques à base de nickel, alliage de nickel-palladium, fer, yttrium, platine, ou cobalt.

15. Elément selon l'une des revendications 5, 9, 11, **caractérisé en ce que** les nanotubes de carbone comprennent des nanotubes de type monofeuillet.

16. Elément selon l'une des revendications 5, 9, 11, 14, **caractérisé en ce que** les nanotubes de carbone comprennent des nanotubes de type multifeuillet.

17. Elément selon l'une des revendications précédentes, **caractérisé en ce que** le matériau constitutif du conducteur inférieur et/ou du conducteur supérieur est du cuivre, de l'aluminium, du siliciure de nickel ou du siliciure de cobalt.

18. Procédé de fabrication d'un élément destiné à interconnecter au moins deux conducteurs d'un circuit microélectronique, comprenant :

    - une étape de réalisation d'un premier conducteur, dit conducteur inférieur ;
    - une étape de réalisation d'une couche d'un premier diélectrique sur le conducteur inférieur ;
    - une étape de réalisation d'un second conducteur, dit conducteur supérieur, sur la couche de diélectrique ;
    - une étape de réalisation d'une cavité débouchant d'une part sur le conducteur inférieur et d'autre part sur le conducteur supérieur,

    le procédé étant **caractérisé en ce que** le conducteur supérieur forme un pont au dessus du conducteur inférieur et la cavité forme au niveau où elle débouche sur le conducteur supérieur deux évents de part et d'autre de ce dernier, le procédé comprenant en outre les étapes suivantes :

    - réalisation du motif du conducteur inférieur dans une couche dudit diélectrique au moyen d'une technique de type Damascène ;
    - dépôt d'une couche de catalyseur de croissance de nanotubes de carbone, précédé ou non du dépôt d'une couche de barrière de diffusion ;
    - dépôt de la couche de premier diélectrique et gravure d'une cavité débouchant sur la couche de catalyseur ;
    - remplissage de ladite cavité par dépôt d'un second diélectrique ;
    - réalisation du conducteur supérieur dans le second diélectrique au moyen d'une technique de type Damascène ;
    - gravure sélective du second diélectrique ;
    - croissance de nanotubes de carbone.

19. Procédé selon la revendication 18, **caractérisé en ce que** l'étape de gravure sélective du second diélectrique est suivie d'un dépôt directif d'une couche inhibitrice de la croissance de nanotubes de carbone, de sorte que ladite couche inhibitrice couvre l'intérieur de ladite cavité, à l'exception d'une zone au fond de la cavité au regard de la face inférieure du conducteur supérieur.

20. Procédé selon la revendication 18 ou 19, **caractérisé en ce qu'**une couche de contact électrique est déposée après le dépôt du second diélectrique et avant la réalisation du conducteur supérieur.

21. Procédé de fabrication d'un élément destiné à interconnecter au moins deux conducteurs d'un circuit microélectronique, comprenant :

    - une étape de réalisation d'un premier conducteur, dit conducteur inférieur ;

- une étape de réalisation d'une couche d'un premier diélectrique sur le conducteur inférieur ;
- une étape de réalisation d'un second conducteur, dit conducteur supérieur, sur la couche de diélectrique ;
- une étape de réalisation d'une cavité débouchant d'une part sur le conducteur inférieur et d'autre part sur le conducteur supérieur,

le procédé étant **caractérisé en ce que** le conducteur supérieur forme un pont au dessus du conducteur inférieur et la cavité forme au niveau où elle débouche sur le conducteur supérieur deux évents de part et d'autre de ce dernier, le procédé comprenant en outre les étapes suivantes :

- réalisation du motif du conducteur inférieur dans une couche dudit diélectrique au moyen d'une technique de type Damascène ;
- dépôt de la couche de premier diélectrique et gravure d'une cavité débouchant sur le conducteur inférieur ;
- remplissage de ladite cavité par dépôt d'un second diélectrique ;
- réalisation d'une couche de catalyseur de croissance de nanotubes de carbone ainsi que du conducteur supérieur dans le second diélectrique au moyen d'une technique de type Damascène ;
- gravure sélective du second diélectrique;
- croissance de nanotubes de carbone.

**22.** Procédé selon la revendication 21, **caractérisé en ce que** la réalisation de la couche de catalyseur est suivie du dépôt d'une couche de barrière de diffusion.

**23.** Procédé selon la revendication 21 ou 22, **caractérisé en ce que** la couche de catalyseur et, le cas échéant la couche de barrière de diffusion, est/sont déposée(s) à travers un masque dur formant un surplomb au dessus de flancs de gravure définissant les motifs du conducteur supérieur.

**24.** Procédé selon l'une des revendications 21 à 23, **caractérisé en ce qu'**une couche de contact électrique est déposée directement sur le conducteur inférieur, avant le dépôt de la couche de diélectrique.

**25.** Procédé selon l'une des revendications 18 à 24, **caractérisé en ce qu'**il comprend une étape de croissance de nanotubes de carbone à partir de la couche de catalyseur.

**26.** Procédé selon la revendication 25, **caractérisé en ce qu'**après ladite étape de croissance de nanotubes, on procède au dépôt d'une seconde couche de matériau diélectrique recouvrant le conducteur supérieur et que l'on planarise par polissage de la structure ainsi obtenue jusqu'à faire apparaître le conducteur supérieur à la surface de ladite structure.

**27.** Procédé selon la revendication 26, **caractérisé en ce que** l' on itère les étapes du procédé selon les revendications 18 à 20 ou bien 18, 21 à 25, puis que l'on effectue l'étape définie en revendication 26, le conducteur supérieur d'une itération courante jouant le rôle du conducteur inférieur à l'itération suivante.

## Claims

**1.** Element for interconnecting at least two conductors of a microelectronic circuit, including:

- a first conductor (210), referred to as lower conductor;
- a dielectric layer (230) on said first conductor;
- a second conductor (220), referred to as upper conductor, on said dielectric layer;
- a cavity (240) in the dielectric layer, emerging on the one hand onto the lower conductor and, on the other hand onto the upper conductor,

**characterised in that**:

- the conductor (220) forms a bridge above the lower conductor (210) and that the cavity (240) forms, at a level where it emerges onto the upper conductor, two vents (243) on both sides of the latter;
- a catalyst layer, favouring the growth of carbon nanotubes, is provided on the upper face of said lower conductor or said lower face of said upper conductor; and that
- said element further includes carbon nanotubes formed from said catalyst layer.

**2.** Element according to claim 1, **characterised in that** said catalyst layer (260) is situated on the upper face of said lower conductor.

**3.** Element according to claim 2, **characterised in that** it includes a diffusion barrier layer between the upper face of the lower conductor (210) and the catalyst layer (260).

**4.** Element according to claim 2 or 3, **characterised in that** it includes a layer (261) for inhibiting the growth of carbon nanotubes, said inhibition layer being deposited on the catalyst layer (260), the former layer covering a zone corresponding to the orthogonal projection of the vents on the latter.

**5.** Element according to one of the claims 2 to 4, **characterised in that it includes an array of electrically conductive nanotubes (250) situated in the cavity, said array extending from the catalyst layer (260) to the lower face of the upper conductor.

6. Element according to one of the claims 2 to 4, **characterised in that** it includes an electrical contact layer (223) situated directly under the upper conductor.

7. Element according to claim 1, **characterised in that** said catalyst layer (260) is situated on the lower face of said upper conductor (220).

8. Element according to claim 7, **characterised in that** it includes a diffusion barrier layer between the lower face of the upper conductor (220) and the catalyst layer (260).

9. Element according to claim 7 or 8, **characterised in that** it includes an array of carbon nanotubes (250) situated in the cavity, said array extending from the catalyst layer (260) to the upper face of the lower conductor (210).

10. Element according to claim 7 or 8, **characterised in that** it includes an electrical contact layer (211) situated directly on the lower conductor.

11. Element according to claim 6 or 10, **characterised in that** it includes an array of carbon nanotubes (250) situated in the cavity, said array extending from the catalyst layer to the electrical contact layer (211, 223).

12. Element according to one of the claims 6, 10, 11, **characterised in that** the constitutive material of the electrical contact layer is palladium or nickel.

13. Element according to claim 3 or 8, **characterised in that** the constitutive material of the diffusion barrier layer is titanium, titanium nitride, tantalum or tantalum nitride.

14. Element according to one of the claims 2 to 13, **characterised in that** said catalyst layer includes nickel-, nickel-palladium alloy-, iron-, yttrium-, platinum-, or cobalt-based metallic nanoparticles.

15. Element according to one of the claims 5, 9, 11, **characterised in that** the carbon nanotubes include single-wall type nanotubes.

16. Element according to one of the claims 5, 9, 11, 14, **characterised in that** the carbon nanotubes include multi-wall type nanotubes.

17. Element according to any preceding claim, **charac-** terised in that the constitutive material of the lower conductor and/or the upper conductor is copper, aluminium, nickel or cobalt silicide.

18. Method of manufacturing an element for interconnecting at least two conductors of a microelectronic circuit, including:

- a step of realisation of a first conductor, referred to as lower conductor;
- a step of realisation of a first dielectric layer on the lower conductor;
- a step of realisation of a second conductor, referred to as upper conductor, on the dielectric layer;
- a step of realisation of a cavity emerging, on the one hand, onto the lower conductor and, on the other hand, onto the upper conductor,

the method being **characterised in that** the upper conductor forms a bridge above the lower conductor and the cavity forms, at the level where it emerges onto the upper conductor, two vents on both sides of the latter, the method further comprising the following steps:

- realisation of the design of the lower conductor in a layer of said dielectric by a damascene-type technique;
- deposition of a catalyst layer of favouring the growth of carbon nanotubes, preceded or not by the deposition of a diffusion barrier layer;
- deposition of the initial dielectric layer and etching of a cavity emerging on the catalyst layer;
- filling of said cavity by deposition of a second dielectric;
- realisation of the upper conductor in the second dielectric by a damascene-type technique;
- selective etching of the second dielectric;
- growing carbon nanotubes.

19. Method according to claim 18, **characterised in that** the selective etching step of the second dielectric is followed by a direct deposition of a layer for inhibiting the growth of carbon nanotubes, such that said inhibition layer covers the interior of said cavity, with the exception of an area at the bottom of the cavity facing the lower side of the upper conductor.

20. Method according to claim 18 or 19, **characterised in that** an electrical contact layer is deposited after the deposition of the second dielectric and before the realisation of the upper conductor.

21. Method of manufacturing an element for interconnecting at least two conductors of a microelectronic circuit, including:

- a step of realisation of a first conductor, referred to as lower conductor;
- a step of realisation of a first dielectric layer on the lower conductor;
- a step of realisation of a second conductor, referred to as upper conductor, on the dielectric layer;
- a step of realisation of a cavity emerging, on the one hand, onto the lower conductor and, on the other hand, onto the upper conductor,

the method being **characterised in that** the upper conductor forms a bridge above the lower conductor and the cavity forms, at the level where it emerges onto the upper conductor, two vents on both sides of the latter, the method further comprising the following steps:

- realisation of the design of the lower conductor in a layer of said dielectric by a damascene-type technique;
- deposition of the first dielectric layer and etching of a cavity emerging on the lower conductor;
- filling of said cavity by the deposition of a second dielectric;
- realisation of a catalyst layer favouring the growth of carbon nanotubes as well as the upper conductor in the second dielectric by a damascene-type technique;
- selective etching of the second dielectric;
- growing carbon nanotubes.

22. Method according to claim 21, **characterised in that** the realisation of the catalyst layer is followed by the deposition of a diffusion barrier layer.

23. Method according to claim 21 or 22, **characterised in that** the catalyst layer and, if applicable, the diffusion barrier layer, is/are deposited through a hard mask forming an overhang above the etching edges defining the designs of the upper conductor.

24. Method according to one of the claims 21 to 23, **characterised in that** an electrical contact layer is deposited directly onto the lower conductor, before the deposition of the dielectric layer.

25. Method according to one of the claims 18 to 24, **characterised in that** it includes a step of growing carbon nanotubes from the catalyst layer.

26. Method according to claim 25, **characterised in that** after said step of growing nanotubes, the next step is a deposition of a second layer of dielectric material covering the upper conductor and that the structure thus obtained is planarised by polishing until the upper conductor becomes apparent on the surface of said structure.

27. Method according to claim 26, **characterised in that** the steps of the method according to claims 18 to 20 or 18, 21 to 25, are iterated before performing the step defined in claim 26, the upper conductor of a current iteration playing the role of the lower conductor in the following iteration.

**Patentansprüche**

1. Element zum Verbinden wenigstens eines ersten Leiters (210) und eines zweiten Leiters (230) einer mikroelektronischen Schaltung, umfassend:

   - den ersten Leiter (210), genannt unterer Leiter;
   - eine dielektrische Schicht (230) auf dem ersten Leiter;
   - den zweiten Leiter (220), genannt oberer Leiter, auf der dielektrischen Schicht;
   - einen Hohlraum (240) in der dielektrischen Schicht, der einerseits auf den unteren Leiter und andererseits auf den oberen Leiter mündet,

   **dadurch gekennzeichnet, dass**:

   der obere Leiter (220) eine Brücke über den unteren Leiter (210) bildet, und dass der Hohlraum (240) in dem Bereich, wo er auf den oberen Leiter mündet, zwei Luftlöcher (243) auf beiden Seiten dieses Letztgenannten bildet; eine Katalysatorschicht, die das Wachstum von Kohlenstoff-Nanoröhren begünstigt, auf der oberen Fläche des unteren Leiters oder auf der unteren Fläche des oberen Leiters vorgesehen ist; und dass das Element ferner Kohlenstoff-Nanoröhren umfasst, die ausgehend von der Katalysatorschicht gebildet sind.

2. Element nach Anspruch 1, **dadurch gekennzeichnet, dass** die Katalysatorschicht (260) an der oberen Fläche des unteren Leiters angeordnet ist.

3. Element nach Anspruch 2, **dadurch gekennzeichnet, dass** es eine Diffusionsbarriereschicht zwischen der oberen Fläche des unteren Leiters (210) und der Katalysatorschicht (260) umfasst.

4. Element nach Anspruch 2 oder 3, **dadurch gekennzeichnet, dass** es eine Schicht (261) zur Verhinderung des Wachstums von Kohlenstoff-Nanoröhren umfasst, wobei die Verhinderungsschicht auf der Katalysatorschicht (260) abgelagert ist, wobei die Ablagerung eine Zone bedeckt, die der orthogonalen Projektion der Luftlöcher auf diese Letztgenannte entspricht.

5. Element nach einem der Ansprüche 2 bis 4, **dadurch**

**gekennzeichnet, dass** es ein Bündel von elektrisch leitenden Nanoröhren (250) umfasst, das in dem Hohlraum angeordnet ist, wobei sich das Bündel von der Katalysatorschicht (260) zu der unteren Fläche des oberen Leiters erstreckt.

**6.** Element nach einem der Ansprüche 2 bis 4, **dadurch gekennzeichnet, dass** es eine Elektrokontaktschicht (223) umfasst, die direkt unter dem oberen Leiter angeordnet ist.

**7.** Element nach Anspruch 1, **dadurch gekennzeichnet, dass** die Katalysatorschicht (260) auf der unteren Fläche des oberen Leiters (220) angeordnet ist.

**8.** Element nach Anspruch 7, **dadurch gekennzeichnet, dass** es eine Diffusionsbarriereschicht zwischen der unteren Fläche des oberen Leiters (220) und der Katalysatorschicht (260) umfasst.

**9.** Element nach Anspruch 7 oder 8, **dadurch gekennzeichnet, dass** es ein Bündel von Kohlenstoff-Nanoröhren (250) umfasst, das in dem Hohlraum angeordnet ist, wobei sich das Bündel von der Katalysatorschicht (260) zur oberen Fläche des unteren Leiters (210) erstreckt.

**10.** Element nach Anspruch 7 oder 8, **dadurch gekennzeichnet, dass** es eine Elektrokontaktschicht (211) umfasst, die direkt auf dem unteren Leiter angeordnet ist.

**11.** Element nach Anspruch 6 oder 10, **dadurch gekennzeichnet, dass** es ein Bündel von Kohlenstoff-Nanoröhren (250) umfasst, das in dem Hohlraum angeordnet ist, wobei sich das Bündel von der Katalysatorschicht zur Elektrokontaktschicht (211, 223) erstreckt.

**12.** Element nach einem der Ansprüche 6, 10, 11, **dadurch gekennzeichnet, dass** das Material, aus dem die Elektrokontaktschicht gebildet ist, Palladium oder Nickel ist.

**13.** Element nach Anspruch 3 oder 8, **dadurch gekennzeichnet, dass** das Material, aus dem die Diffusionsbarriereschicht gebildet ist, Titan ist, Titannitrid, Tantal oder Tantalnitrid.

**14.** Element nach einem der Ansprüche 2 bis 13, **dadurch gekennzeichnet, dass** die Katalysatorschicht metallische Nanopartikel auf Basis von Nickel, einer Nickel-Palladium-Legierung, Eisen, Yttrium, Platin oder Kobalt umfasst.

**15.** Element nach einem der Ansprüche 5, 9, 11, **dadurch gekennzeichnet, dass** die Kohlenstoff-Nanoröhren Nanoröhren vom Typ Monoblatt umfassen.

**16.** Element nach einem der Ansprüche 5, 9, 11, 14, **dadurch gekennzeichnet, dass** die Kohlenstoff-Nanoröhren Nanoröhren vom Typ Multiblatt umfassen.

**17.** Element nach einem der vorhergehenden Ansprüche, **dadurch gekennzeichnet, dass** das Material, aus dem der untere Leiter und/oder der obere Leiter gebildet ist, Kupfer ist, Aluminium, Nickelsilizid oder Kobaltsilizid.

**18.** Verfahren zur Herstellung eines Elements zur Verbindung von wenigstens zwei Leitern einer mikroelektronischen Schaltung, umfassend:

     - einen Schritt der Realisierung eines ersten Leiters, genannt unterer Leiter;
     - einen Schritt der Realisierung einer Schicht aus einem ersten Dielektrikum auf dem unteren Leiter;
     - einen Schritt der Realisierung eines zweiten Leiters, genannt oberer Leiter, auf der dielektrischen Schicht;
     - einen Schritt der Realisierung eines Hohlraums, der einerseits auf den unteren Leiter und andererseits auf den oberen Leiter mündet,

wobei das Verfahren **dadurch gekennzeichnet ist, dass** der obere Leiter eine Brücke über den unteren Leiter bildet, und dass der Hohlraum in dem Bereich, wo er auf den oberen Leiter mündet, zwei Luftlöcher auf beiden Seiten dieses Letztgenannten bildet, wobei das Verfahren ferner die folgenden Schritte umfasst:

     - Realisieren des Musters des unteren Leiters in einer Schicht aus dem Dielektrikum mit Hilfe einer Technik vom Damaszener-Typ;
     - Ablagern einer Kohlenstoff-Nanoröhren-Wachstumskatalysatorschicht, gegebenenfalls nach einer vorangegangenen Ablagerung einer Diffusionsbarriereschicht;
     - Ablagern der Schicht aus dem ersten Dielektrikum und Gravieren eines Hohlraums, der auf die Katalysatorschicht mündet;
     - Füllen des Hohlraums durch Ablagern eines zweiten Dielektrikum;
     - Realisieren des oberen Leiters in dem zweiten Dielektrikum mit Hilfe einer Technik vom Damaszener-Typ;
     - selektives Gravieren des zweiten Dielektrikums;
     - Wachsen von Kohlenstoff-Nanoröhren.

**19.** Verfahren nach Anspruch 18, **dadurch gekennzeichnet, dass** auf den Schritt des selektiven Gravierens des zweiten Dielektrikums eine gerichtete Ablagerung einer Schicht zur Verhinderung des Wachstums von Kohlenstoff-Nanoröhren folgt, derart, dass die Verhinderungsschicht das Innere des Hohlraums bedeckt, ausgenommen eine Zone am Boden des Hohlraums gegenüber der unteren Fläche des oberen Leiters.

20. Verfahren nach Anspruch 18 oder 19, **dadurch gekennzeichnet, dass** eine Elektrokontaktschicht nach der Ablagerung des zweiten Dielektrikums und vor der Realisierung des oberen Leiters abgelagert wird.

21. Verfahren zur Herstellung eines Elements zur Verbindung von wenigstens zwei Leitern einer mikroelektronischen Schaltung, umfassend:

    - einen Schritt der Realisierung eines ersten Leiters, genannt unterer Leiter;
    - einen Schritt der Realisierung einer Schicht aus einem ersten Dielektrikum auf dem unteren Leiter;
    - einen Schritt der Realisierung eines zweiten Leiters, genannt oberer Leiter, auf der dielektrischen Schicht;
    - einen Schritt der Realisierung eines Hohlraums, der einerseits auf den unteren Leiter und andererseits auf den oberen Leiter mündet,

wobei das Verfahren **dadurch gekennzeichnet ist, dass** der obere Leiter eine Brücke über den unteren Leiter bildet, und dass der Holraum in dem Bereich, wo er auf den oberen Leiter mündet, zwei Luftlöcher auf beiden Seiten dieses Letztgenannten bildet, wobei das Verfahren ferner die folgenden Schritte umfasst:

    - Realisieren des Musters des unteren Leiters in einer Schicht aus dem Dielektrikum mit Hilfe einer Technik vom Damaszener-Typ;
    - Ablagern der Schicht aus dem ersten Dielektrikum und Gravieren eines Hohlraums, der auf den unteren Leiter mündet;
    - Füllen des Hohlraums durch Ablagern eines zweiten Dielektrikums;
    - Realisierten einer Kohlenstoff-Nanoröhren-Wachstumskatalysatorschicht sowie des oberen Leiters in dem zweiten Dielektrikum mit Hilfe einer Technik vom Damaszener-Typ;
    - selektives Gravieren des zweiten Dielektrikums,
    - Wachsen von Kohlenstoff-Nanoröhren.

22. Verfahren nach Anspruch 21, **dadurch gekennzeichnet, dass** auf die Realisierung der Katalysatorschicht die Ablagerung einer Diffusionsbarriereschicht folgt.

23. Verfahren nach Anspruch 21 oder 22, **dadurch gekennzeichnet, dass** die Katalysatorschicht und gegebenfalls die Diffusionsbarriereschicht durch eine harte Maske gebildet ist/sind, die eine Auskragung über Gravurflanken bildet, die die Muster des oberen Leiters definieren.

24. Verfahren nach einem der Ansprüche 21 bis 23, **dadurch gekennzeichnet, dass** eine Elektrokontaktschicht direkt auf dem unteren Leiter vor der Ablagerung der dielektrischen Schicht abgelagert wird.

25. Verfahren nach einem der Ansprüche 18 bis 24, **dadurch gekennzeichnet, dass** es einen Schritt des Wachsens von Kohlenstoff-Nanoröhren ausgehend von der Katalysatorschicht umfasst.

26. Verfahren nach Anspruch 25, **dadurch gekennzeichnet, dass** man nach dem Schritt des Wachses von Nanoröhren zur Ablagerung einer zweiten Schicht aus dielektrischem Material übergeht, die den oberen Leiter bedeckt, und dass man sie durch Polieren der derart erhaltenen Struktur planarisiert, bis der obere Leiter an der Oberfläche der Struktur erscheint.

27. Verfahren nach Anspruch 26, **dadurch gekennzeichnet, dass** man die Schritte des Verfahrens nach den Ansprüchen 18 bis 20 oder auch 18, 21 bis 25 iteriert, dass man dann den im Anspruch 26 definierten Schritt ausführt, wobei der obere Leiter einer gegenwärtigen Iteration die Rolle des unteren Leiters bei der nachfolgenden Iteration spielt.

**Fig. 1**

**Fig. 2a**

**Fig. 2b**

**Fig. 2c**

**Fig. 3a**

**Fig. 3b**

**Fig. 4a**

**Fig. 4b**

**Fig. 5a**

**Fig. 5b**

**Fig. 6a**

**Fig. 6b**

230 240

**Fig. 6c**

235

**Fig. 6d**

221

**Fig. 6e**

223 220

**Fig. 6f**

223  220

**Fig. 6g**

240    220

223

**Fig. 6h**

261

**Fig. 6i**

250

**Fig. 6j**

210

230

**Fig. 7a**

211

**Fig. 7b**

230

240

**Fig. 7c**

235

**Fig. 7d**

225  221

**Fig. 7e**

260

220

**Fig. 7f**

260

220

**Fig. 7g**

240

**Fig. 7h**

250

**Fig. 7i**

230

**Fig. 8a**

220

**Fig. 8b**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0161753 A

- EP 1361608 A

**Littérature non-brevet citée dans la description**

- **F. KREUPL.** Carbon Nanotubes for Interconnect Applications. *Microelectron. Eng.,* 2002, vol. 64, 399-408